# EUROPEAN PATENT SPECIFICATION

(11) **EP 3 712 663 B1**
(45) Date of publication and mention of the grant of the patent: **20.09.2023**
(21) Application number: 18878095.1
(22) Date of filing: 02.11.2018
(51) Int. Cl.: G02B 5/20, C03C 17/00, C09K 11/02, C09K 11/77, C09K 11/08

(54) **WAVELENGTH CONVERSION ELEMENT**
WELLENLÄNGENUMWANDLUNGSELEMENT
ÉLÉMENT DE CONVERSION DE LONGUEUR D'ONDE

(30) Priority: 16.11.2017 JP 2017221095
(43) Date of publication of application: 23.09.2020
(73) Proprietor: Panasonic Intellectual Property Management Co., Ltd., Osaka-shi, Osaka 540-6207 (JP)
(72) Inventor: NAKAMURA Masahiro, Osaka 540-6207 (JP); OKUNO, Tatsuya, Osaka 540-6207 (JP)
(74) Representative: Müller-Boré & Partner Patentanwälte PartG mbB
(86) International application number: PCT/JP2018/040818
(87) International publication number: WO 2019/098057

(56) References cited:
- WO-A1-2014/023617
- JP-A- 2015 089 898
- JP-A- 2016 034 891
- JP-A- 2017 215 507
- JP-A- 2017 215 568

## Description

The present disclosure relates to a wavelength converter using photoluminescence.

Heretofore, as an optical conversion layer using photoluminescence, there has been known an optical conversion layer composed of a plurality of optical conversion inorganic particles which emit light by being irradiated with excitation light; and a binder layer that holds the plurality of optical conversion inorganic particles. When the optical conversion layer is formed on a surface of a substrate portion, a wavelength converter composed of the substrate portion and the optical conversion layer is obtained. It is preferable that the substrate portion and the optical conversion layer have high adhesion strength.

For example, in PTL 1, there is disclosed a wavelength converter including: a quartz glass substrate; and a wavelength conversion quartz glass layer that is formed on a surface of the quartz glass substrate and contains phosphor particles. Moreover, in the wavelength converter of PTL 1, a concentration of phosphor in the wavelength conversion quartz glass layer is distributed from a high concentration to a low concentration from the glass substrate toward a surface of the wavelength conversion quartz glass layer.

FIG. 4 is a schematic cross-sectional view of the wavelength converter according to PTL 1. As illustrated in FIG. 4, a wavelength converter 100C according to PTL 1 includes: a substrate portion 10 made of glass; and a wavelength conversion quartz glass layer 130C as an optical conversion layer. In the wavelength conversion quartz glass layer 130C, optical conversion inorganic particles 40 are held by an inorganic binder portion 150C. The inorganic binder portion 150C is formed into a quartz glass layer 52 composed of an amorphous binder. In the wavelength converter 100C, a concentration of the optical conversion inorganic particles 40 in the wavelength conversion quartz glass layer 130C is distributed from a high concentration to a low concentration from the substrate portion 10 toward a surface of the wavelength conversion quartz glass layer 130C.

[PTL 1] Japanese Unexamined Patent Application Publication No. 2016-34891
Further, JP 2015-089898 A describes an optical semiconductor device including an inorganic phosphor powder, a curable resin composition containing the inorganic phosphor powder, a wavelength conversion member composed of a cured product of the curable resin composition, and a cured product; and
WO 2014/023617 A1 describes a conversion-medium for an optoelectronic semiconductor component and a method for producing a conversion-medium lamina.

However, the wavelength converter disclosed in PTL 1 is required to be heated at approximately 550°C at the time of being manufactured. Therefore, in the case where the substrate portion is made of metal such as aluminum in order to reflect light on the substrate portion, it is apprehended that the metal of the substrate portion and the optical conversion inorganic particles may be degraded by being heated as described above.

The present disclosure has been made in consideration of the above-described problem. It is an object of the present disclosure to provide a wavelength converter that prevents the substrate portion and the optical conversion inorganic particles from being degraded by being heated and has high adhesion between the substrate portion and the optical conversion layer.

In order to solve the above-described problem, a wavelength converter according to an aspect of the present disclosure includes: a substrate portion; and an optical conversion layer including optical conversion inorganic particles and an inorganic binder portion that mutually holds the optical conversion inorganic particles, and being formed on the substrate portion, wherein the inorganic binder portion includes: an amorphous binder; and granular binder particulates with an average particle size smaller than an average particle size of the optical conversion inorganic particles, and wherein, in a case where, in the optical conversion layer, a portion present close to the substrate portion with respect to an intermediate plane in a thickness direction of the optical conversion layer is defined as a substrate-side portion, and a portion present remote from the substrate portion with respect to the intermediate plane is defined as a non-substrate-side portion, when a ratio of an average volume concentration of the binder particulates in the substrate-side portion with respect to an average volume concentration of the optical conversion inorganic particles in the substrate-side portion is defined as a substrate-side binder particulate concentration ratio RFs. and, when a ratio of an average volume concentration of the binder particulates in the non-substrate-side portion with respect to an average volume concentration of the optical conversion inorganic particles in the non-substrate-side portion is defined as a non-substrate-side binder particulate concentration ratio RFo, the substrate-side binder particulate concentration ratio RFs is larger than the non-substrate-side binder particulate concentration ratio RFo.

FIG. 1 is a schematic cross-sectional view of a wavelength converter according to an embodiment and Example 1.
FIG. 2 is a schematic cross-sectional view of a wavelength converter according to Comparative example 1.
FIG. 3 is a schematic cross-sectional view of a wavelength converter according to Comparative example 2.
FIG. 4 is a schematic cross-sectional view of a wavelength converter according to PTL 1.

Hereinafter, a wavelength converter according to an embodiment will be described with reference to the drawings.

### [Wavelength Converter]

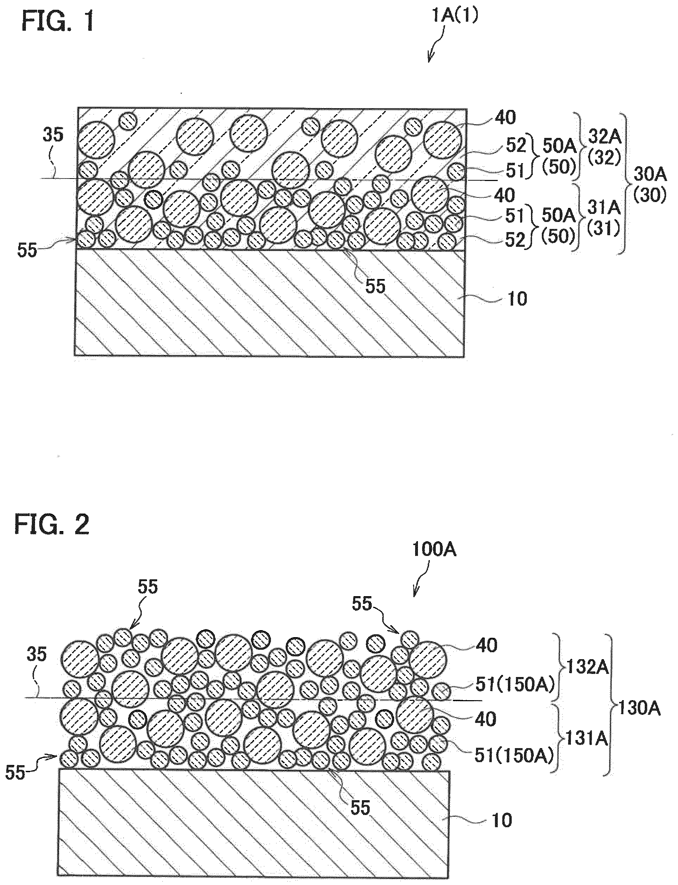

FIG. 1 is a schematic cross-sectional view of a wavelength converter according to the embodiment. As illustrated in FIG. 1, a wavelength converter 1A (1) includes a substrate portion 10, and an optical conversion layer 30A (30) formed on the substrate portion 10. When optical conversion inorganic particles 40 in the optical conversion layer 30A receive excitation light emitted from an excitation light source (not shown), the wavelength converter 1A radiates, to an outside thereof, light subjected to optical conversion by the optical conversion inorganic particles 40.

### (Substrate portion)

The substrate portion 10 is a member that has functions to reinforce the optical conversion layer 30A formed on a surface of the substrate portion 10, and to impart good optical and thermal characteristics to the optical conversion layer 30A by selection of a material and thickness thereof.

As a material of the substrate portion 10, for example, there are used metal that is not translucent and translucent ceramics such as glass and sapphire. As the metal, for example, aluminum, copper or the like is used. The substrate portion 10 made of metal is preferable since light reflectivity thereof is excellent. Moreover, the substrate portion 10 made of ceramics is preferable since translucency thereof is excellent. As ceramics, silicon nitride, alumina or the like is used. A thermal expansion coefficient of aluminum is 23×10⁻⁶ to 24×10⁻⁶/K, and a thermal expansion coefficient of copper is 16×10⁻⁶ to 17×10⁻⁶/K. A thermal expansion coefficient of silicon nitride is 2×10⁻⁶ to 4×10⁻⁶/K, and a thermal expansion coefficient of alumina is 5×10⁻⁶ to 8×10⁻⁶/K.

It is preferable that the material of the substrate portion 10 be metal since it is easy to improve heat dissipation. That is, if the substrate portion 10 is made of metal, then thermal conductivity of the substrate portion 10 increases. Accordingly, in the optical conversion layer 30A, it becomes possible to efficiently remove heat generated in a process where excitation light is converted to fluorescent light 70, and the like. Therefore, it is preferable that the substrate portion 10 be made of metal since it is easy to suppress temperature quenching of the optical conversion inorganic particles 40 and degradation and burning of an inorganic binder portion 50A.

Meanwhile, in the case where the material of the substrate portion 10 is a translucent material such as translucent ceramics, it becomes possible to apply light to the optical conversion inorganic particles 40 in the optical conversion layer 30A via the substrate portion 10. Herein, the fact that a material has translucency means that the material is transparent with respect to the visible light (with a wavelength of 380 nm to 800 nm). Moreover, in this embodiment, being transparent means that light transmittance in a material is preferably 80% or more, more preferably 90% or more. Moreover, it is preferable that an extinction coefficient for the visible light by the material for use in the substrate portion 10 be as low as possible since it is possible to sufficiently apply light via the substrate portion 10 to the optical conversion inorganic particles 40 in the optical conversion layer 30A. As described above, it is preferable that the substrate portion 10 be made of a translucent material since it becomes easy to construct a compact system. As described above, it is preferable that the substrate portion 10 be translucent since it becomes easy to construct a compact system.

Incidentally, the above-described metal usually has lower heat resistance than the above-described ceramics. Therefore, in the case where the substrate portion 10 is made of metal, it is preferable that the substrate portion 10 not be heated at a high temperature when the optical conversion layer 30A is provided on the surface thereof. As will be described later, it is possible to form the optical conversion layer 30A of the wavelength converter 1A at a relatively low temperature. Therefore, the wavelength converter 1A is preferable in the case where the substrate portion 10 is made of metal.

It is preferable that reflectance of a surface of the substrate portion 10, which is close to the optical conversion layer 30A, be 90% or more since extraction efficiency of light from the surface of the optical conversion layer 30A increases. As a method of setting the reflectance of the surface of the substrate portion 10, which is close to the optical conversion layer 30A, to 90% or more, for example, a method using the substrate portion 10 made of metal in which reflectance of a surface is 90% or more is mentioned.

Moreover, as another method of setting the reflectance of the surface of the substrate portion 10, which is close to the optical conversion layer 30A, to 90% or more, there is mentioned a method of forming the substrate portion 10 into a two-layer structure including a substrate body and a reflective film formed on a surface of the substrate body, the surface having reflectance of 90% or more. In the case of this two-layer structure, a material of the substrate body is not particularly limited, and for example, metal such as aluminum and translucent ceramics can be used.

Moreover, when the substrate portion 10 is formed into the above-described two-layer structure, the substrate portion 10 can be formed into a three-layer structure by further forming a protective film for protecting the reflective film on the surface of the reflective film. For example, when the reflective film is an aluminum thin film, the substrate portion 10 can be formed into the three-layer structure by forming a protective film for suppressing oxidation of aluminum on the surface of the reflective film.

### (Optical conversion layer)

The optical conversion layer 30A (30) includes the optical conversion inorganic particles 40 and the inorganic binder portion 50A (50) that mutually holds the optical conversion inorganic particles 40, and is formed on the substrate portion 10. A film thickness of the optical conversion layer 30A is, for example, 10 µm to 1000 µm. It is preferable that the film thickness of the optical conversion layer 30A stay within the above-described range since the obtained wavelength converter becomes one that has high thermal conductivity and light extraction efficiency and scatters light largely.

### <Optical conversion inorganic particle>

The optical conversion inorganic particles 40 are particles made of an optical conversion material that is an inorganic compound capable of photoluminescence. A type of the optical conversion inorganic particles 40 is not particularly limited as long as the optical conversion inorganic particles 40 are capable of photoluminescence. As the optical conversion inorganic particles, for example, used are particles containing a nitride-based optical conversion material activated by Eu²⁺, and crystalline particles with a garnet structure made ofYAG, that is, Y₃Al₅O₁₂. Among optical conversion inorganic particles, the particles containing the nitride-based optical conversion material activated by Eu²⁺ are preferable since the excitation light is converted to light with a longer wavelength. Moreover, as the particles containing the nitride-based optical conversion material activated by Eu²⁺, for example, used are optical conversion inorganic particles containing (Sr,Ca)AlSiN₃:Eu, silicon nitride Si₃N₄:Eu, and SiAlON:Eu.

An average particle size of optical conversion inorganic particles 40 having a large particle size is usually 100 µm or less, preferably 30 µm or less. It is preferable that the average particle size of the optical conversion inorganic particles 40 stay within the above-described range since it is possible to reduce a spot diameter of output light output from the wavelength converter 1A because guidance of light trapped in the optical conversion inorganic particles 40 due to total reflection is limited to a range of the particle size. Moreover, it is preferable that the average particle size of the optical conversion inorganic particles 40 stay within the above-described range since it is possible to produce the optical conversion inorganic particles 40 in an inexpensive production process such as a coating method while reducing color variation of the output light of the wavelength converter 1A.

The average particle size of the optical conversion inorganic particles 40 having a large particle size is obtained by observing the arbitrarily preprocessed optical conversion layer 30A by a scanning electron microscope (SEM) or the like and obtaining an average value of diameters of particles of which number is sufficiently significant from a statistical viewpoint, for example, 100.

Moreover, it is possible to determine a composition of the optical conversion inorganic particles 40 by a well-known analysis method such as energy dispersive X-ray spectrometry (EDX) and X-ray diffraction analysis (XRD).

The optical conversion inorganic particles 40 may be made of phosphors having the same composition, or may be a mixture of phosphor particles having two or more types of compositions.

It is preferable that a refractive index of the optical conversion inorganic particles 40 be larger than a refractive index of the inorganic binder portion 50A. When the refractive index of the optical conversion inorganic particles 40 is larger than the refractive index of the inorganic binder portion 50A, light is trapped in the inside of the phosphor due to total reflection. Therefore, in in-plane guided light in the inorganic binder portion 50A, components limited to the range of the particle size of the optical conversion inorganic particles 40 are increased. Hence, it is preferable that the refractive index of the optical conversion inorganic particles 40 be larger than the refractive index of the inorganic binder portion 50A since it is easy to reduce the spot diameter of the output light output from the wavelength converter 1A.

In the case where the optical conversion inorganic particles 40 are YAG particles, the refractive index of the optical conversion inorganic particles 40 is 1.8 to 1.9.

### <Inorganic binder portion>

The inorganic binder portion 50A (50) is a member that constitutes the optical conversion layer 30A and mutually holds the optical conversion inorganic particles 40. As illustrated in FIG. 1, the inorganic binder portion 50A includes: an amorphous binder 52; and granular binder particulates 51 with an average particle size smaller than that of the optical conversion inorganic particles 40. The substrate portion 10 and the inorganic binder portion 50A in the optical conversion layer 30A are bonded to each other on an interface therebetween.

### [Binder particulate]

The binder particulates 51A are one component that constitutes the inorganic binder portion 50A, and is composed of a granular inorganic compound with an average particle size smaller than that of the optical conversion inorganic particles 40. The binder particulates 51 usually form fixed bodies 55 in which a large number of binder particulates 51 are fixed, thereby mutually holding the optical conversion inorganic particles 40. Herein, the fixing means that solids such as the binder particulates 51 are fixed to one another by intermolecular force. In the case where the binder particulates 51 form the fixed bodies 55 of binder particulates, the optical conversion inorganic particles 40 are held by only the fixed bodies 55 of the binder particulates or by cooperation between the fixed bodies 55 of the binder particulates and the amorphous binder 52.

Note that, in the optical conversion layer 30A, since the amorphous binder 52 is included therein, it is not always necessary for the binder particulates 51 to form the fixed bodies 55 of the binder particulates. In this case, the binder particulates 51 mutually hold the optical conversion inorganic particles 40 by cooperation between the binder particulates 51 and the amorphous binder 52.

In the case where the fixed bodies 55 of the binder particulates are formed, a shape of each of the binder particulates 51 which constitute the fixed bodies 55 of the binder particulates is maintained. Therefore, air gaps are formed between the adjacent binder particulates 51 in the fixed bodies 55 of the binder particulates. In the case where the fixed bodies 55 of the binder particulates and the amorphous binder 52 cooperate with each other to mutually hold the optical conversion inorganic particles 40, the amorphous binder 52 adheres to peripheries of the fixed bodies 55 of the binder particulates, or is impregnated into the air gaps formed between the binder particulates 51. That is, the amorphous binder 52 adheres to the peripheries of the fixed bodies 55 of the binder particulates, or is impregnated into the air gaps formed between the binder particulates 51, thereby mutually holding the optical conversion inorganic particles 40 in cooperation with the fixed bodies 55 of the binder particulates.

Meanwhile, in the case where the fixed bodies 55 of the binder particulates are not formed, the optical conversion inorganic particles 40 are mutually held mainly by the amorphous binder 52, and the binder particulates 51 auxiliarly performs the mutual holding of the optical conversion inorganic particles 40, which is mainly performed by the amorphous binder 52.

As will be described later, an average volume concentration of the binder particulates 51 in the optical conversion layer 30A is not uniform, and differs depending on places in the optical conversion layer 30A. Usually, in a non-substrate-side portion 32 in the optical conversion layer 30A, the average volume concentration of the binder particulates decreases more than in a substrate-side portion 31. Therefore, in such a portion as the non-substrate-side portion 32, where the average volume concentration of the binder particulates 51 is relatively low, the fixed bodies 55 of the binder particulates are not formed in some cases. For example, in the optical conversion layer 30A, in the non-substrate-side portion 32 to be described later, which is located remote from the substrate portion 10, the average volume concentration of the binder particulates 51 is relatively low, and accordingly, the fixed bodies 55 of the binder particulates are not usually formed. Moreover, the fixed bodies 55 of the binder particulates are usually generated by drying a mixture of the optical conversion inorganic particles 40 and the binder particulates 51 at the time of manufacturing the optical conversion layer 30A. Therefore, the fixed bodies 55 of the binder particulates are not usually formed in the optical conversion layer 30A manufactured without being subjected to such a step.

A material of the binder particulates 51 is, for example, a metal oxide or a fluorine compound. As the metal oxide, for example, used are aluminum oxide, magnesium oxide, zinc oxide, zirconium oxide, and the like. Among them, aluminum oxide, magnesium oxide and zinc oxide are preferable since thermal conductivity of each thereof is high. The zirconium oxide is preferable since a thermal expansion coefficient thereof is relatively large to suppress peeling, which is caused by a difference in thermal expansion coefficient, in the case where a metal substrate made of aluminum or the like is used. As the fluoride, for example, used are magnesium fluoride (refractive index: 1.38); calcium fluoride (refractive index: 1.399), lithium fluoride (refractive index: 1.392) and the like. Among such fluorides, magnesium fluoride is preferable since it is a stable substance, in which a reliability is high, and a refractive index is low. It is preferable that a refractive index of the binder particulates 51 be low since a ratio at which the in-plane guided light is generated in the inorganic binder portion 50A is reduced, and the light extraction efficiency of the wavelength converter 1A is increased, whereby it is possible to reduce the output light spot diameter.

The refractive index of the binder particulates 51 is preferably 1.43 or less, more preferably less than 1.40. It is preferable that the refractive index of the binder particulates 51 stay within the above-described range since the ratio at which the in-plane guided light is generated in the inorganic binder portion 50A is reduced, and the light extraction efficiency of the wavelength converter 1A is increased, whereby it is possible to reduce the output light spot diameter. Usually, the refractive index of the binder particulates 51 is smaller than the refractive index of the optical conversion inorganic particles 40. When the refractive index of the binder particulates 51 is 1.43 or less, a difference thereof from the refractive index of the optical conversion inorganic particles 40 is increased more, and the ratio at which the in-plane guided light is generated in the inorganic binder portion 50A is reduced. Therefore, it is preferable that the refractive index of the binder particulates 51 be 1.43 or less since the light extraction efficiency of the wavelength converter 1A is increased to make it easy to reduce the output light spot diameter.

An average particle size of the binder particulates 51 is usually 10 to 100 nm, preferably 10 to 50 nm, more preferably 15 to 25 nm. It is preferable that the average particle size of the binder particulates 51 stay within the above-described range since fixing strength of the fixed bodies 55 of the binder particulates is high. The average particle size of the binder particulates 51 can be obtained similarly to the average particle size of the optical conversion inorganic particles 40.

The binder particulates 51 can be formed into hollow particles or mesoporous particles. Herein, the mesoporous particles mean porous particles, each of which has a large number of pores with a size from 1 nm to several ten nanometers. When the binder particulates 51 are hollow particles or mesoporous particles, the effective refractive index of the binder particulates 51 becomes a value between the refractive index of the material of the binder particulates 51 and the refractive index (1.0) of the air, and decreases more than the refractive index of the material of the binder particulates 51. Therefore, when the binder particulates 51 are hollow particles or mesoporous particles, such a wavelength converter 1A is obtained, in which the light extraction efficiency from the binder particulates 51 and the inorganic binder portion 50A including the same is high and a power density of the output light is high.

A thermal expansion coefficient of the binder particulates 51 is usually 1×10⁻⁶/K or more, preferably 1×10⁻⁶ to 50×10⁻⁶/K. It is preferable that the thermal expansion coefficient of the binder particulates 51 stay within the above-described range since it is easy to suppress peeling between the substrate portion 10 and the binder particulates 51 in the inorganic binder portion 50.

### [Amorphous binder]

The amorphous binder 52 is one component that constitutes the inorganic binder portion 50A, and is composed of an amorphous inorganic compound. The amorphous binder 52 mutually holds the optical conversion inorganic particles 40 by only the amorphous binder 52 or by cooperation between the amorphous binder 52 and the fixed bodies 55 of the binder particulates.

As will be described later, an average volume concentration of the amorphous binder 52 in the optical conversion layer 30A is not uniform, and differs depending on places in the optical conversion layer 30A. Usually, in the substrate-side portion 31 in the optical conversion layer 30A, the average volume concentration of the amorphous binder 52 decreases more than in the non-substrate-side portion 32. However, a precursor as a raw material of the amorphous binder 52 that is still ungenerated as a product has high fluidity, and accordingly, the amorphous binder 52 is impregnated into the air gaps between the binder particulates 51.

The material of the amorphous binder 52 is, for example, silica glass (refractive index: 1.44 to 1.50) using, as a precursor, at least either one of polysilazane and a polysilazane derivative. It is preferable that the material of the amorphous binder 52 be silica glass using at least either one of polysilazane and a polysilazane derivative as a precursor since the fluidity of the precursor is excellent. That is, it is preferable that the material of the amorphous binder 52 be the above-described silica glass since the inorganic binder portion 50A that is dense is obtained because the precursor excellent in fluidity is impregnated into the air gaps between the fixed bodies 55 of the binder particulates 51.

Herein, the polysilazane is a polymer having a cyclic or linear Si-N skeleton structure in which one or more Si-N bonds are continuous, where all of side chains of Si and N are H. Moreover, the polysilazane derivative is a polymer having a structure in which groups other than H, for example, hydrocarbon groups are substituted for one or more side chains or terminal groups which constitute the polysilazane. Herein, as the hydrocarbon groups, for example, alkyl groups, phenyl groups and the like are mentioned. As the polysilazane, for example, perhydropolysilazane is used. Note that the precursor means a fluidic substance before the silica glass as a product is cured.

By a silica conversion reaction of the following Formula (1), at least either one of the polysilazane and the polysilazane derivative, which are described above, forms silica glass by silica conversion in which at least a part of the Si-N skeleton structure changes to a three-dimensional mesh structure of SiO₄ tetrahydrons.

### [Chem. 1]

### (-SiH₂NH-)+2H₂O → (-SiO₂-)+NH₃+2H₂ (1)

Note that, in the above-described Formula (1), (-SiH₂NH-) represents a part present in the structures of the polysilazane and the polysilazane derivative. Each of the polysilazane and the polysilazane derivative includes one or more (-SiH₂NH-). Moreover, in the above-described Formula (1), (-SiO₂-) represents a part present in the structure of the silica glass after the silica conversion reaction. The silica glass includes one or more (-SiO₂-).

Herein, the silica glass means a substance having a three-dimensional mesh structure in which SiO₄ tetrahydrons share oxygen on vertices, in which N is substituted for a part of O of the SiO₄ tetrahydrons according to needs, and a content of N is reduced more than in the polysilazane or the polysilazane derivative, which is a precursor. Herein, tetrahydrons obtained by substitution of N for a part of O of the SiO₄ tetrahydrons are referred to as substituted tetrahydrons. The silica glass has a three-dimensional mesh structure composed of only the SiO₄ tetrahydrons, a three-dimensional mesh structure composed of the SiO₄ tetrahydrons and the substituted tetrahydrons, or a three-dimensional mesh structure composed of only the substituted tetrahydrons.

As described above, the optical conversion layer 30A includes the optical conversion inorganic particles 40 and the inorganic binder portion 50A, and the inorganic binder portion 50A includes the binder particulates 51 and the amorphous binder 52. That is, the optical conversion layer 30A includes the optical conversion inorganic particles 40, the binder particulates 51, and the amorphous binder 52. However, in the optical conversion layer 30A, the average volume concentrations of the above-described substances are not uniform, and the average volume concentrations of the above-described substances differ between a substrate portion 10-side portion of the optical conversion layer 30A, which is close to the substrate portion 10 in a thickness direction of the optical conversion layer 30A, and a portion of the optical conversion layer 30A, which is remote from the substrate portion 10 in the thickness direction. A description will be given below of the average volume concentrations of the substances in the optical conversion layer 30A and ratios of the average volume concentrations of the substances.

### <Substrate-side portion and non-substrate-side portion>

First, for the sake of convenience, the optical conversion layer 30A is classified into the portion of the optical conversion layer 30A, which is close to the substrate portion 10, in the thickness direction, and the portion of the optical conversion layer 30A, which is remote from the substrate portion 10. Specifically, in the optical conversion layer 30A, a portion present close to the substrate portion 10 with respect to an intermediate plane 35 in the thickness direction of the optical conversion layer is defined as the substrate-side portion 31, and a portion present remote from the substrate portion 10 with respect to the intermediate plane 35 therein is defined as the non-substrate-side portion 32. Herein, the intermediate plane 35 is a plane defined by assuming to be composed of an aggregate of points at which such a thickness of the optical conversion layer 30A is halved. In FIG. 1, the intermediate plane 35 is illustrated. Since the optical conversion layer 30A of FIG. 1 has a uniform thickness, the intermediate plane 35 is a plane parallel to the surface of the substrate portion 10. Therefore, the intermediate plane 35 is illustrated as a line in FIG. 1. The optical conversion layer 30A becomes equal to the sum of the substrate-side portion 31 and the non-substrate-side portion 32.

### <Binder particulate concentration ratio RF>

In the optical conversion layer 30A, a ratio of the average volume concentration of the binder particulates 51 with respect to the average volume concentration of the optical conversion inorganic particles 40, that is, a substrate-side binder particulate concentration ratio RF is different between the substrate-side portion 31 and the non-substrate-side portion 32. A description will be given below of a substrate-side binder particulate concentration ratio RFs of the substrate-side portion 31 and a non-substrate-side binder particulate concentration ratio RFo of the non-substrate-side portion 32.

First, the ratio of the average volume concentration CFs (vol%) of the binder particulates 51 in the substrate-side portion 31 with respect to the average volume concentration COs (vol%) of the optical conversion inorganic particles 40 in the substrate-side portion 31 is defined as a substrate-side binder particulate concentration ratio RFs. Herein, the binder particulates 51 also include such binder particulates 51 which constitute the fixed bodies 55 of the binder particulates. Note that the average volume concentration COs of the above-described optical conversion inorganic particles 40 and the average volume concentration CFs of the binder particulates 51 are average values in the substrate-side portion 31. Therefore, it is not necessary that the substrate-side portion 31 be uniform in a volume concentration of the optical conversion inorganic particles 40 and a volume concentration of the binder particulates 51. Specifically, the substrate-side portion 31 may include a portion in which the volume concentration of the optical conversion inorganic particles 40 is different from the average volume concentration COs of the optical conversion inorganic particles 40, and a portion in which the volume concentration of the binder particulates 51 is different from the average volume concentration CFs of the binder particulates 51.

Meanwhile, the ratio of the average volume concentration CFo (vol%) of the binder particulates 51 in the non-substrate-side portion 32 with respect to the average volume concentration COo (vol%) of the optical conversion inorganic particles 40 in the non-substrate-side portion 32 is defined as a non-substrate-side binder particulate concentration ratio RFo. Herein, the binder particulates 51 also include such binder particulates 51 which constitute the fixed bodies 55 of the binder particulates. Note that the average volume concentration COo of the above-described optical conversion inorganic particles 40 and the average volume concentration CFo of the binder particulates 51 are average values in the non-substrate-side portion 32. Therefore, it is not necessary that the non-substrate-side portion 32 be uniform in the volume concentration of the optical conversion inorganic particles 40 and the volume concentration of the binder particulates 51. Specifically, the non-substrate-side portion 32 may include a portion in which the volume concentration of the optical conversion inorganic particles 40 is different from the average volume concentration COo of the optical conversion inorganic particles 40, and a portion in which the volume concentration of the binder particulates 51 is different from the average volume concentration CFo of the binder particulates 51.

In the optical conversion layer 30A, the substrate-side binder particulate concentration ratio RFs is larger than the non-substrate-side binder particulate concentration ratio RF_{O}. That is, in the optical conversion layer 30A, the ratio of the average volume concentration of the binder particulates 51 with respect to the average volume concentration of the optical conversion inorganic particles 40 is larger in the substrate-side portion 31 than in the non-substrate-side portion 32.

Therefore, in the optical conversion layer 30A, since a ratio of the binder particulates 51 with respect to the optical conversion inorganic particles 40 is larger in the substrate-side portion 31 than in the non-substrate-side portion 32, the optical conversion inorganic particles 40 are firmly held by the binder particulates 51 in the substrate-side portion 31. Moreover, since the refractive index of the binder particulates 51 is smaller than the refractive indices of the optical conversion inorganic particles 40 and the amorphous binder 52, light smoothly travels from the binder particulates 51 toward the optical conversion inorganic particles 40. In the optical conversion layer 30A, since the concentration of the binder particulates 51 is higher in the substrate-side portion 31 than in the non-substrate-side portion 32, light smoothly travels from the binder particulates 51 toward the optical conversion inorganic particles 40 in the substrate-side portion 31, and high light extraction efficiency is achieved.

### <Amorphous binder concentration ratio RA>

Moreover, in the optical conversion layer 30A, it is preferable that a ratio of an average volume concentration of the amorphous binder 52 with respect to the average volume concentration of the optical conversion inorganic particles 40, that is, an amorphous binder concentration ratio RA be different between the substrate-side portion 31 and the non-substrate-side portion 32. A description will be given below of a substrate-side amorphous binder concentration ratio RA_{S} of the substrate-side portion 31 and a non-substrate-side amorphous binder concentration ratio RA_{O} of the non-substrate-side portion 32.

First, a ratio of the average volume concentration CAs (vol%) of the amorphous binder 52 in the substrate-side portion 31 with respect to the average volume concentration COs (vol%) of the optical conversion inorganic particles 40 in the substrate-side portion 31 is defined as a substrate-side amorphous binder concentration ratio RA_{S}. Note that the average volume concentration COs of the above-described optical conversion inorganic particles 40 and the average volume concentration CAs of the amorphous binder 52 are average values in the substrate-side portion 31. Therefore, it is not necessary that the substrate-side portion 31 be uniform in a volume concentration of the optical conversion inorganic particles 40 and a volume concentration of the amorphous binder 52. Specifically, the substrate-side portion 31 may include a portion in which the volume concentration of the optical conversion inorganic particles 40 is different from the average volume concentration COs of the optical conversion inorganic particles 40, and a portion in which the volume concentration of the amorphous binder 52 is different from the average volume concentration CA_{S} of the amorphous binder 52.

Meanwhile, the ratio of the average volume concentration CAo (vol%) of the amorphous binder 52 in the non-substrate-side portion 32 with respect to the average volume concentration CO_{O} (vol%) of the optical conversion inorganic particles 40 in the non-substrate-side portion 32 is defined as a non-substrate-side amorphous binder concentration ratio RAo. Note that the average volume concentration COo of the above-described optical conversion inorganic particles 40 and the average volume concentration CAo of the amorphous binder 52 are average values in the non-substrate-side portion 32. Therefore, it is not necessary that the non-substrate-side portion 32 be uniform in the volume concentration of the optical conversion inorganic particles 40 and the volume concentration of the amorphous binder 52. Specifically, the non-substrate-side portion 32 may include a portion in which the volume concentration of the optical conversion inorganic particles 40 is different from the average volume concentration COo of the optical conversion inorganic particles 40, and a portion in which the volume concentration of the amorphous binder 52 is different from the average volume concentration CAo of the amorphous binder 52.

In the optical conversion layer 30A, it is preferable that the non-substrate-side amorphous binder concentration ratio RAo be larger than the substrate-side amorphous binder concentration ratio RA_{S}. That is, in the optical conversion layer 30A, it is preferable that the ratio of the average volume concentration of the amorphous binder 52 with respect to the average volume concentration of the optical conversion inorganic particles 40 be larger in the non-substrate-side portion 32 than in the substrate-side portion 31.

Therefore, in the optical conversion layer 30A, since the ratio of the amorphous binder 52 with respect to the optical conversion inorganic particles 40 is larger in the non-substrate-side portion 32 than in the substrate-side portion 31, excitation light is efficiently supplied to the optical conversion inorganic particles 40 via the amorphous binder 52. That is, in the optical conversion layer 30A, excitation light made incident from a surface of the non-substrate-side portion 32 is sufficiently supplied to the non-substrate-side portion 32 and the substrate-side portion 31, and accordingly, light emission efficiency of the whole of the optical conversion layer 30A increases.

### <Manufacturing method of wavelength converter>

The wavelength converter 1A is manufactured, for example, by the following manufacturing method.

First, prepared are a phosphor dispersion liquid A for fabricating the substrate-side portion 31 and a phosphor dispersion liquid B for fabricating the non-substrate-side portion 32. For example, as the phosphor dispersion liquid A, prepared is a dispersion liquid in which the optical conversion inorganic particles 40 and the binder particulates 51 are dispersed in water. Meanwhile, as the phosphor dispersion liquid B, a dispersion liquid is prepared by mixing the optical conversion inorganic particles 40, the binder particulates 51 and a fluidic raw material of the amorphous binder 52 with one another.

Next, the phosphor dispersion liquid A is applied on the surface of the substrate portion 10, and is dried at room temperature, and the fixed bodies 55 of the binder particulates 51 are formed on the surface of the substrate portion 10. Moreover, the phosphor dispersion liquid B is applied on the surfaces of the fixed bodies 55 of the binder particulates 51, and a part of the phosphor dispersion liquid B is impregnated into the fixed bodies 55 of the binder particulates 51, and is thereafter dried at room temperature. When a part of the phosphor dispersion liquid B is impregnated into the fixed bodies 55 of the binder particulates 51 and is dried, the substrate-side portion 31 in which the amorphous binder 52 is impregnated into the fixed bodies 55 of the binder particulates 51 is formed. Moreover, when the phosphor dispersion liquid B applied on the surface of the substrate-side portion 31 is dried at room temperature, the non-substrate-side portion 32 is formed on the surface of the substrate-side portion 31.

In accordance with the above-described manufacturing method of the wavelength converter, the wavelength converter 1A can be manufactured at room temperature. Therefore, in accordance with the above-described manufacturing method of the wavelength converter, the wavelength converter 1 can be provided, which prevents the substrate portion 10 and the optical conversion inorganic particles 40 from being degraded by being heated and has high adhesion between the substrate portion 10 and the optical conversion layer 30.

### (Function of wavelength converter)

First, for the wavelength converter 1A illustrated in FIG. 1, excitation light is applied to the surface of the optical conversion layer 30A from an excitation light source (not shown). The excitation light travels in the optical conversion layer 30A in an order of the non-substrate-side portion 32 and the substrate-side portion 31. Herein, in the case where the non-substrate-side amorphous binder concentration ratio RA_{O} is larger than the substrate-side amorphous binder concentration ratio RAs, the excitation light easily travels through the inside of the non-substrate-side portion 32. This is because the excitation light easily travels through the inside of the amorphous binder 52 when the ratio of the concentration of the amorphous binder 52 with respect to the optical conversion inorganic particles 40 is large in the non-substrate-side portion 32 and small in the substrate-side portion 31.

The excitation light that travels through the inside of the optical conversion layer 30A in an order of the non-substrate-side portion 32 and the substrate-side portion 31 travels in the binder particulates 51 with an increased concentration in the substrate-side portion 31. Generally, the refractive indices of the amorphous binder 52, the binder particulates 51 and the optical conversion inorganic particles 40 increase in an ascending order. Therefore, the excitation light smoothly travels in an order of the amorphous binder 52, the binder particulates 51 and the optical conversion inorganic particles 40 or in an order of the amorphous binder 52 and the optical conversion inorganic particles 40.

When the excitation light is applied to the optical conversion inorganic particles 40, the optical conversion inorganic particles 40 radiate fluorescence. The radiated fluorescence travels as it is through the inside of the optical conversion layer 30A, or travels through the inside of the optical conversion layer 30A after being reflected by the surface of the substrate portion 10, and is radiated as emitted light from the surface of the optical conversion layer 30A.

### (Effect of wavelength converter)

In accordance with the wavelength converter 1A, the wavelength converter is obtained, which prevents the substrate portion 10 and the optical conversion inorganic particles 40 from being degraded by being heated and has high adhesion between the substrate portion 10 and the optical conversion layer 30A. Moreover, the substrate-side binder particulate concentration ratio RFs is larger than the non-substrate-side binder particulate concentration ratio RF_{O}, and accordingly, has high adhesion to the substrate.

Further, the wavelength converter 1A can be manufactured at room temperature, and accordingly, the wavelength converter 1A can be provided, which prevents the substrate portion 10 and the optical conversion inorganic particles 40 from being degraded by being heated and has high adhesion between the substrate portion 10 and the optical conversion layer 30.

### EXAMPLES

Hereinafter, this embodiment will be described more in detail by examples; However, this embodiment is not limited to these examples.

### [Example 1]

### (Preparation of phosphor dispersion liquid P1)

Powder of magnesium fluoride nanoparticles (refractive index: 1.38) with an average particle size of 40 nm, which was produced by a gas phase method, was mixed with ion exchange water, and was dispersed by an ultrasonic wave, whereby 15 mass% of a magnesium fluoride dispersion liquid D1 was obtained. Moreover, YAG particles with an average particle size of 20 µm were prepared as phosphor (optical conversion inorganic particles). The magnesium fluoride dispersion liquid D1 and the YAG particles were mixed with each other in a weight ratio of 1: 2, and a phosphor dispersion liquid P1 was prepared.

### (Preparation of phosphor dispersion liquid P2)

As the polysilazane that is the raw material of the amorphous binder, Perhydropolysilazane Aquamica (registered trademark) NL120A made by Merck Performance Materials Ltd. was used. The polysilazane, the above-described YAG particles and the magnesium fluoride dispersion liquid D1 were mixed with one another in a weight ratio of 1: 2: 0.01, and a phosphor dispersion liquid P2 was prepared.

### (Fabrication of wavelength converter)

The phosphor dispersion liquid P1 was applied on a surface of a substrate portion composed of an aluminum plate by using an applicator equipped with a bar coater, and was dried by being left standing at 25°C. After the drying, a dry coating film M1 with a thickness of 50 µm was formed on the surface of the substrate portion. It was found that, as illustrated in FIG. 1, the dry coating film M1 has a structure in which the fixed bodies 55 of the magnesium fluoride nanoparticles which are the binder particulates 51 mutually hold the YAG particles 40 which are the optical conversion inorganic particles.

Next, the phosphor dispersion liquid P2 was applied on the surface of the dry coating film M1 on the substrate portion by using the above-described applicator, and was dried by being left standing at 25°C. After the drying, a dry coating film M2 with a thickness of 50 µm was formed on the surface of the dry coating film M1.

Thus, a wavelength converter including the substrate portion composed of an aluminum plate and an optical conversion layer was obtained. In the optical conversion layer, a portion with a thickness of 50 µm, which is derived from the dry coating film M1, and a portion with a thickness of 50 µm, which is formed by the application of the phosphor dispersion liquid P2, was laminated on the substrate portion in this order.

When a structure of the wavelength converter according to Example 1 was investigated, it was found that this wavelength converter has a similar structure to that of the wavelength converter 1A illustrated in FIG. 1. Therefore, in FIG. 1, the wavelength converter according to Example 1 is illustrated as the wavelength converter 1A, and the optical conversion layer is illustrated as the optical conversion layer 30A.

Note that the optical conversion layer 30A of the wavelength converter 1A according to Example 1 includes the portion derived from the dry coating film M1 and the portion formed by the application of the phosphor dispersion liquid P2, both of which have the same thickness. Therefore, since the intermediate plane 35 is located on the boundary between these portions, the portion derived from the dry coating film M1 corresponds to the substrate-side portion 31A, and the portion formed by the application of the phosphor dispersion liquid P2 corresponds to the non-substrate-side portion 32.

It was found that, in the substrate-side portion 31A in the optical conversion layer 30A of Example 1, the polysilazane impregnated into the air gaps of the fixed bodies 55 of the magnesium fluoride nanoparticles 51, which mutually hold the YAG particles 40, is cured and becomes the silica glass 52 as the amorphous binder. Moreover, it was found that, in the substrate-side portion 31A, the YAG particles 40 are mutually held by the fixed bodies 55 of the magnesium fluoride nanoparticles 51 and the silica glass 52.

Meanwhile, it was found that, in the non-substrate-side portion 32A in the optical conversion layer 30A of Example 1, the YAG particles 40 and the magnesium fluoride nanoparticles 51 are dispersed in the silica glass 52 as the amorphous binder composed by the curing of the polysilazane. Moreover, it was found that, in the non-substrate-side portion 32A, the YAG particles 40 are mutually held by the silica glass 52 mainly.

### (Comparison between substrate-side binder particulate concentration ratio RFs and non-substrate-side binder particulate concentration ratio RFo)

Examined are the substrate-side binder particulate concentration ratio RF_{S} and the non-substrate-side binder particulate concentration ratio RFo in the optical conversion layer 30A of Example 1.

The binder particulate concentration ratio RF is a ratio of the average volume concentration of the binder particulates 51 with respect to the average volume concentration of the optical conversion inorganic particles 40.

Moreover, the substrate-side binder particulate concentration ratio RF_{S} is a ratio of the average volume concentration of the binder particulates 51 with respect to the average volume concentration of the optical conversion inorganic particles 40 in the substrate-side portion 31A.

Furthermore, the non-substrate-side binder particulate concentration ratio RF_{O} is a ratio of the average volume concentration of the binder particulates 51 with respect to the average volume concentration of the optical conversion inorganic particles 40 in the non-substrate-side portion 32A.

As seen from FIG. 1 and the above-described test conditions, with regard to the ratio (binder particulate concentration ratio RF) of the average volume concentration of the binder particulates 51 with respect to the average volume concentration of the optical conversion inorganic particles 40, the value thereof in the substrate-side portion 31A is larger than the value thereof in the non-substrate-side portion 32A.

As described above, in Example 1, the substrate-side binder particulate concentration ratio RFs that is the binder particulate concentration ratio RF of the substrate-side portion 31A became larger than the non-substrate-side binder particulate concentration ratio RF_{O} that is the binder particulate concentration ratio RF of the non-substrate-side portion 32A.

### [Comparative example 1]

### (Preparation of phosphor dispersion liquid P1)

A phosphor dispersion liquid P1 was prepared in a similar way to Example 1.

### (Fabrication of wavelength converter)

The phosphor dispersion liquid P1 was applied on a surface of a substrate portion composed of an aluminum plate by using an applicator equipped with a bar coater, and was dried by being left standing at 25°C. After the drying, a dry coating film M2 with a thickness of 100 µm was formed on the surface of the substrate portion.

Thus, a wavelength converter 100A including the substrate portion composed of an aluminum plate and an optical conversion layer composed of the dry coating film M2 with a thickness of 100 µm was obtained.

When a structure of the wavelength converter 100A according to Comparative example 1 was investigated, it was found that the optical conversion layer composed of the dry coating film M2 has a structure in which the fixed bodies 55 of the magnesium fluoride nanoparticles 51 mutually hold the YAG particles 40.

Results are illustrated in FIG. 2. FIG. 2 is a schematic cross-sectional view of the wavelength converter 100A according to Comparative example 1.

As illustrated in FIG. 2, the wavelength converter 100A (100) according to Comparative example 1 included the substrate portion 10 composed of an aluminum plate, and an optical conversion layer 130A (130) formed on the substrate portion 10. The optical conversion layer 130A included the YAG particles 40 as the optical conversion inorganic particles, and an inorganic binder portion 150A that mutually held the YAG particles 40. It was found that the inorganic binder portion 150A forms the fixed bodies 55 of a large number of the magnesium fluoride nanoparticles 51, and that the optical conversion inorganic particles 40 are mutually held by the fixed bodies 55 of the magnesium fluoride nanoparticles 51.

Note that, in FIG. 2, for the sake of convenience, in the optical conversion layer 130A, a portion present close to the substrate portion 10 with respect to an intermediate plane 35 in a thickness direction of the optical conversion layer 130A is displayed as a substrate-side portion 131A, and a portion present remote from the substrate portion 10 with respect to the intermediate plane 35 therein is displayed as a non-substrate-side portion 132A.

However, in the optical conversion layer 130A of the wavelength converter 100A according to Comparative example 1, in the thickness direction thereof, concentration gradients of the optical conversion inorganic particles 40 and the magnesium fluoride nanoparticles 51 are not substantially present. Therefore, in the optical conversion layer 130A illustrated in FIG. 2, the substrate-side portion 131A and the non-substrate-side portion 132A have substantially the same structure. Hence, in the wavelength converter 100A according to Comparative example 1, the substrate-side binder particulate concentration ratio RFs and the non-substrate-side binder particulate concentration ratio RF_{O} are the same.

### [Comparative example 2]

### (Preparation of phosphor dispersion liquid P2)

A phosphor dispersion liquid P2 was prepared in a similar way to Example 1.

### (Fabrication of wavelength converter)

The phosphor dispersion liquid P2 was applied on a surface of a substrate portion composed of an aluminum plate by using an applicator equipped with a bar coater, and was dried by being left standing at 25°C. After the drying, a dry coating film M3 with a thickness of 100 µm was formed on the surface of the substrate portion.

Thus, a wavelength converter 100A including the substrate portion composed of an aluminum plate and an optical conversion layer composed of the dry coating film M3 with a thickness of 100 µm was obtained.

When a structure of the wavelength converter 100B according to Comparative example 2 was investigated, it was found that, in the optical conversion layer composed of the dry coating film M3, the YAG particles 40 and the magnesium fluoride nanoparticles 51 are dispersed in the silica glass 52 as the amorphous binder composed by the curing of the polysilazane.

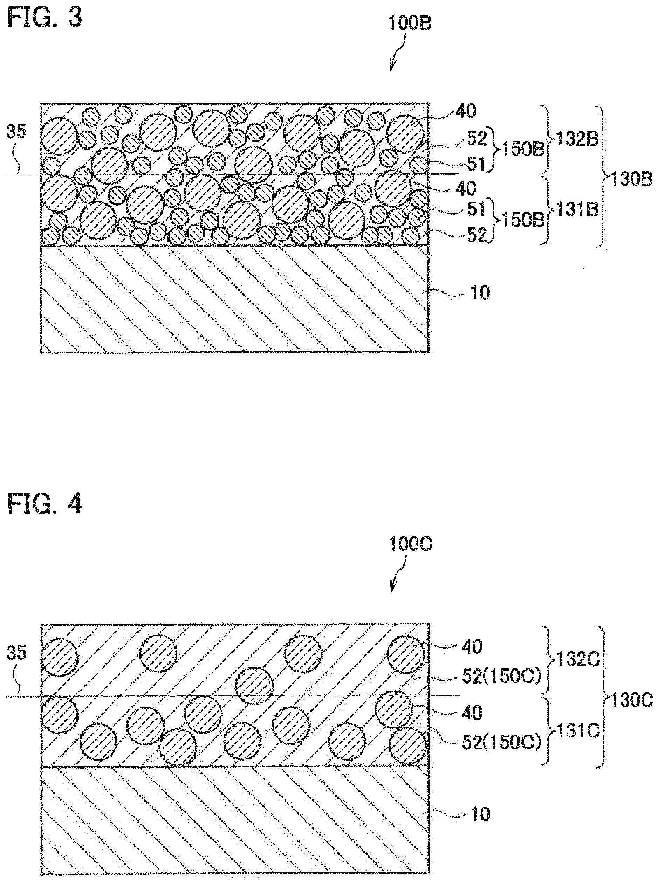

Results are illustrated in FIG. 3. FIG. 3 is a schematic cross-sectional view of the wavelength converter 100B according to Comparative example 2.

As illustrated in FIG. 3, the wavelength converter 100B (100) according to Comparative example 2 included a substrate portion 10 composed of an aluminum plate, and an optical conversion layer 130B (130) formed on the substrate portion 10. The optical conversion layer 130B included the YAG particles 40 as the optical conversion inorganic particles, and an inorganic binder portion 150B that mutually held the YAG particles 40. It was found that the inorganic binder portion 150B is one in which the magnesium fluoride nanoparticles 51 are dispersed in the silica glass 52 as the amorphous binder composed by the curing of the polysilazane.

Note that, in FIG. 3, for the sake of convenience, in the optical conversion layer 130B, a portion present close to the substrate portion 10 with respect to an intermediate plane 35 in a thickness direction of the optical conversion layer 130B is displayed as a substrate-side portion 131B, and a portion present remote from the substrate portion 10 with respect to the intermediate plane 35 therein is displayed as a non-substrate-side portion 132B.

However, in the optical conversion layer 130B of the wavelength converter 100B according to Comparative example 2, in the thickness direction thereof, concentration gradients of the optical conversion inorganic particles 40, the magnesium fluoride nanoparticles 51 and the silica glass 52 are not substantially present. Therefore, in the optical conversion layer 130B illustrated in FIG. 3, the substrate-side portion 131B and the non-substrate-side portion 132B have substantially the same structure. Hence, in the wavelength converter 100B according to Comparative example 2, the substrate-side binder particulate concentration ratio RFs and the non-substrate-side binder particulate concentration ratio RF_{O} are the same.

### (Evaluation of film adhesion strength of wavelength converter)

For each of the wavelength converters according to Example 1 and Comparative examples 1 and 2, film adhesion strength between the substrate portion 10 and the optical conversion layer was measured.

Specifically, Cellotape (registered trademark) made by Nichiban Co., Ltd. was pasted onto the surface of the optical conversion layer of the wavelength converter, and thereafter, was peeled off with a fixed force, whereby a degree of collapse of the optical conversion layer in a portion from which the Cellotape was peeled was visually confirmed.

As a result, in Comparative example 1, observed was a state in which a surface layer was peeled in a part of the surface of the optical conversion layer 130A, specifically, a 30% or more portion in an area of the surface of the optical conversion layer 130A. This is presumed to be because, at the time of peeling the Cellotape, there collapsed such a surface layer portion of the fixed bodies 55 of the magnesium fluoride nanoparticles 51 in the optical conversion layer 130A, and the magnesium fluoride nanoparticles 51 were peeled.

Specifically, the above-described peeling is presumed to have been caused because the fixing strength of the fixed bodies 55 of the magnesium fluoride nanoparticles 51 in the inside of the optical conversion layer 130A is lower than the adhesin strength between the substrate portion 10 and the optical conversion layer 130A.

Moreover, in Comparative example 2, observed was a state in which an entirety (80% or more of an area of the surface of the optical conversion layer 130B) of the optical conversion layer 130B was peeled from the substrate portion 10. This is presumed to be because, since a bonding force between the substrate portion 10 and the optical conversion layer 130B was low, the entirety of the optical conversion layer 130B was peeled at the time of peeling the Cellotape.

Specifically, the above-described peeling is presumed to have been caused because the bonding strength between the substrate portion 10 and the optical conversion layer 130B was lower than a bonding strength by the silica glass 52 and the like in the inside of the optical conversion layer 130B. The reason why the bonding strength by the silica glass 52 and the like in the inside of the optical conversion layer 130B is high is presumed to be that a composition of the optical conversion layer 130B is substantially uniform in the optical conversion layer 130B.

In contrast, in Example 1, observed was a state in which, peeled from the substrate portion 10 was a part of the optical conversion layer 30A, specifically, 5% or less portion in the area of the surface of the optical conversion layer 130A. However, such a peeled area was significantly small in comparison with Comparative examples 1 and 2.

Although the contents of this embodiment have been described above in accordance with the examples, it is obvious to those skilled in the art that this embodiment is not limited to the description of these and that various modifications and improvements are possible.

In accordance with the present disclosure, the wavelength converter can be provided, which prevents the substrate portion and the optical conversion inorganic particles from being degraded by being heated and has high adhesion between the substrate portion and the optical conversion layer.

1, 1A, 100, 100A, 100B, 100C WAVELENGTH CONVERTER
10 SUBSTRATE PORTION
30, 30A, 130, 130A, 130B OPTICAL CONVERSION LAYER
130C WAVELENGTH CONVERSION QUARTZ GLASS LAYER
31, 131A, 131B, 131C SUBSTRATE-SIDE PORTION
32, 132A, 132B, 132C NON-SUBSTRATE-SIDE PORTION
35 INTERMEDIATE PLANE
40 OPTICAL CONVERSION INORGANIC PARTICLE (PHOSPHOR PARTICLE, YAG PARTICLE)
50, 50A, 150, 150A, 150B, 150C INORGANIC BINDER PORTION
51 BINDER PARTICULATE (MAGNESIUM FLUORIDE NANOPARTICLE)
52 AMORPHOUS BINDER (QUARTZ GLASS LAYER, SILICA GLASS)
55 FIXED BODY OF BINDER PARTICULATES (FIXED BODY OF MAGNESIUM FLUORIDE NANOPARTICLES)

## Claims

1. A wavelength converter (1) comprising:
a substrate portion (10); and
an optical conversion layer (30) including optical conversion inorganic particles (40) and an inorganic binder portion (50) that mutually holds the optical conversion inorganic particles (40), and being formed on the substrate portion (10),
wherein the inorganic binder portion (50) includes: an amorphous binder (52); and granular binder particulates (51) with an average particle size smaller than an average particle size of the optical conversion inorganic particles (40), and
wherein, in a case where, in the optical conversion layer (30), a portion present close to the substrate portion (10) with respect to an intermediate plane (35) in a thickness direction of the optical conversion layer (30) is defined as a substrate-side portion (31), and a portion present remote from the substrate portion (10) with respect to the intermediate plane (35) is defined as a non-substrate-side portion (32),
when a ratio of an average volume concentration of the binder particulates (51) in the substrate-side portion (31) with respect to an average volume concentration of the optical conversion inorganic particles (40) in the substrate-side portion (31) is defined as a substrate-side binder particulate concentration ratio RFs and,
when a ratio of an average volume concentration of the binder particulates (51) in the non-substrate-side portion (32) with respect to an average volume concentration of the optical conversion inorganic particles (40) in the non-substrate-side portion (32) is defined as a non-substrate-side binder particulate concentration ratio RFo,
the substrate-side binder particulate concentration ratio RF_{S} is larger than the non-substrate-side binder particulate concentration ratio RFo.

2. The wavelength converter (1) according to claim 1, wherein the average particle size of the optical conversion inorganic particles (40) is 1 to 100 µm, and the average particle size of the binder particulates (51) is 10 to 100 nm.

3. The wavelength converter (1) according to claim 1 or 2,
wherein, when a ratio of an average volume concentration of the amorphous binder (52) in the substrate-side portion (31) with respect to an average volume concentration of the optical conversion inorganic particles (40) in the substrate-side portion (31) is defined as a substrate-side amorphous binder (52) concentration ratio RA_{S} and,
when a ratio of an average volume concentration of the amorphous binder (52) in the non-substrate-side portion (32) with respect to an average volume concentration of the optical conversion inorganic particles (40) in the non-substrate-side portion (32) is defined as a non-substrate-side amorphous binder concentration ratio RAo,
the non-substrate-side amorphous binder concentration ratio RAo is larger than the substrate-side amorphous binder (52) concentration ratio RAs.

4. The wavelength converter (1) according to any one of claims 1 to 3, wherein a thermal expansion coefficient of the amorphous binder (52) is smaller than a thermal expansion coefficient of the binder particulates (51).

5. The wavelength converter (1) according to any one of claims 1 to 4, wherein the binder particulates (51) are hollow particles or mesoporous particles.

6. The wavelength converter (1) according to any one of claims 1 to 5, wherein a material of the binder particulates (51) is a metal oxide or a fluorine compound.

7. The wavelength converter (1) according to any one of claims 1 to 6, wherein the material of the amorphous binder (52) is silica glass using at least either one of polysilazane and a polysilazane derivative as a precursor.

8. The wavelength converter (1) according to any one of claims 1 to 7, wherein a thermal expansion coefficient of the binder particulates (51) is 1×10⁻⁶/K or more.

9. The wavelength converter (1) according to any one of claims 1 to 7, wherein a refractive index of the binder particulates (51) is 1.43 or less.

10. The wavelength converter (1) according to any one of claims 1 to 9, wherein the substrate portion (10) is made of metal.

## Patentansprüche

1. Wellenlängenwandler (1), umfassend:
einen Substratabschnitt (10); und
eine optische Umwandlungsschicht (30), enthaltend anorganische Teilchen zur optischen Umwandlung (40) und einen anorganischen Bindemittelabschnitt (50), der die anorganischen Teilchen zur optischen Umwandlung (40) gegenseitig hält und auf dem Substratabschnitt (10) ausgebildet ist,
wobei der anorganische Bindemittelabschnitt (50: ein amorphes Bindemittel (52); und körnige Bindemittelteilchen (51) mit einer durchschnittlichen Teilchengröße, die kleiner ist als eine durchschnittliche Teilchengröße der anorganischen Teilchen zur optischen Umwandlung (40), enthält, und
wobei in einem Fall, in dem in der optischen Umwandlungsschicht (30) ein Abschnitt, der in Bezug auf eine Zwischenebene (35) in einer Dickenrichtung der optischen Umwandlungsschicht (30) nahe an dem Substratabschnitt (10) vorhanden ist, als ein substratseitiger Abschnitt (31) definiert ist, und ein Abschnitt, der in Bezug auf die Zwischenebene (35) entfernt von dem Substratabschnitt (10) vorhanden ist, als ein nicht-substratseitiger Abschnitt (32) definiert ist,
wenn ein Verhältnis einer durchschnittlichen Volumenkonzentration der Bindemittelteilchen (51) in dem substratseitigen Abschnitt (31) in Bezug auf eine durchschnittliche Volumenkonzentration der anorganischen Teilchen zur optische Umwandlung (40) in dem substratseitigen Abschnitt (31) als ein substratseitiges Bindemittelteilchen-Konzentrationsverhältnis RFs definiert ist und
wenn ein Verhältnis einer durchschnittlichen Volumenkonzentration der Bindemittelteilchen (51) in dem nicht-substratseitigen Abschnitt (32) in Bezug auf eine durchschnittliche Volumenkonzentration der anorganischen Teilchen zur optischen Umwandlung (40) in dem nicht-substratseitigen Abschnitt (32) als ein nicht-substratseitiges Bindemittelteilchen-Konzentrationsverhältnis RFo definiert ist,
das substratseitige Bindemittelteilchen-Konzentrationsverhältnis RFs größer ist als das nicht-substratseitige Bindemittelteilchen-Konzentrationsverhältnis RFo.

2. Wellenlängenwandler (1) nach Anspruch 1, wobei die durchschnittliche Teilchengröße der anorganischen Teilchen zur optischen Umwandlung (40) 1 bis 100 µm und die durchschnittliche Teilchengröße der Bindemittelteilchen (51) 10 bis 100 nm beträgt.

3. Wellenlängenwandler (1) nach Anspruch 1 oder 2,
wobei, wenn ein Verhältnis einer durchschnittlichen Volumenkonzentration des amorphen Bindemittels (52) in dem substratseitigen Abschnitt (31) in Bezug auf eine durchschnittliche Volumenkonzentration der anorganischen Teilchen zur optischen Umwandlung (40) in dem substratseitigen Abschnitt (31) als ein substratseitiges amorphes Bindemittel-Konzentrationsverhältnis (52) RAs definiert ist und, wenn ein Verhältnis einer durchschnittlichen Volumenkonzentration des amorphen Bindemittels (52) in dem nicht-substratseitigen Abschnitt (32) in Bezug auf eine durchschnittliche Volumenkonzentration der anorganischen Teilchen zur optische Umwandlung (40) in dem nicht-substratseitigen Abschnitt (32) als ein nicht-substratseitiges amorphes Bindemittel-Konzentrationsverhältnis RAo definiert ist, das nicht-substratseitige amorphe Bindemittel-Konzentrationsverhältnis RAo größer ist als das substratseitige amorphe Bindemittel (52)-Konzentrationsverhältnis RAs.

4. Wellenlängenwandler (1) nach einem der Ansprüche 1 bis 3, wobei ein Wärmeausdehnungskoeffizient des amorphen Bindemittels (52) kleiner ist als ein Wärmeausdehnungskoeffizient der Bindemittelteilchen (51).

5. Wellenlängenwandler (1) nach einem der Ansprüche 1 bis 4, wobei die Bindemittelteilchen (51) hohle Teilchen oder mesoporöse Teilchen sind.

6. Wellenlängenwandler (1) nach einem der Ansprüche 1 bis 5, wobei ein Material der Bindemittelteilchen (51) ein Metalloxid oder eine Fluorverbindung ist.

7. Wellenlängenwandler (1) nach einem der Ansprüche 1 bis 6, wobei das Material des amorphen Bindemittels (52) Quarzglas ist, das mindestens eines von Polysilazan und einem Polysilazanderivat als Vorstufe verwendet.

8. Wellenlängenwandler (1) nach einem der Ansprüche 1 bis 7, wobei ein Wärmeausdehnungskoeffizient der Bindemittelteilchen (51) 1 × 10⁻⁶/K oder mehr beträgt.

9. Wellenlängenwandler (1) nach einem der Ansprüche 1 bis 7, wobei ein Brechungsindex der Bindemittelteilchen (51) 1,43 oder weniger beträgt.

10. Wellenlängenwandler (1) nach einem der Ansprüche 1 bis 9, wobei der Substratabschnitt (10) aus Metall hergestellt ist.

## Revendications

1. Convertisseur de longueur d'onde (1) comprenant :
une partie formant substrat (10); et
une couche de conversion optique (30) comprenant des particules inorganiques de conversion optique (40) et une partie de liant inorganique (50) qui maintient entre elles les particules inorganiques de conversion optique (40), et qui est formée sur la partie formant substrat (10),
dans lequel la partie de liant inorganique (50) comprend : un liant amorphe (52) ;
et des particules de liant granulaires (51) présentant une taille moyenne de particule plus petite que la taille moyenne de particules des particules inorganiques de conversion optique (40), et
dans lequel, dans le cas où, dans la couche de conversion optique (30), une partie présente proche de la partie formant substrat (10) par rapport à un plan intermédiaire (35) dans un sens de l'épaisseur de la couche de conversion optique (30), est définie en tant que partie côté substrat (31), et qu'une partie présente éloignée de la partie formant substrat (10) par rapport au plan intermédiaire (35), est définie en tant que partie non côté substrat (32),
lorsque le rapport d'une concentration moyenne en volume des particules de liant (51) dans la partie côté substrat (31) par rapport à une concentration moyenne en volume des particules inorganiques de conversion optique (40) dans la partie côté substrat (31), est définie en tant que rapport de concentration particulaire de liant côté substrat RF_{S}, et
lorsque le rapport d'une concentration moyenne en volume des particules de liant (51) dans la partie non côté substrat (32) par rapport à une concentration moyenne en volume des particules inorganiques de conversion optique (32) dans la partie non côté substrat (40), est définie en tant que rapport de concentration particulaire de liant non côté substrat RFo,
le rapport de concentration particulaire de liant côté substrat RF_{S} est plus grand que le rapport de concentration particulaire de liant non côté substrat RF_{O}.

2. Convertisseur de longueur d'onde (1) selon la revendication 1, dans lequel la taille particulaire moyenne des particules inorganiques de conversion optique (40) va de 1 à 100 µm, et la taille particulaire moyenne des particules de liant (51) va de 10 à 100 nm.

3. Convertisseur de longueur d'onde (1) selon la revendication 1 ou 2,
dans lequel, lorsque le rapport de concentration moyenne en volume du liant amorphe (52) dans la partie côté substrat (31) par rapport à une concentration moyenne en volume des particules inorganiques de conversion optique (40) dans la partie côté substrat (31), est définie en tant que rapport de concentration de liant amorphe côté substrat (52) RAs, et
lorsque le rapport d'une concentration moyenne en volume du liant amorphe (52) dans la partie non côté substrat (32) par rapport à une concentration moyenne en volume des particules inorganiques de conversion optique (40) dans la partie non côté substrat (32), est définie en tant que rapport de concentration de liant amorphe non côté substrat RA_{O,}
le rapport de concentration de liant amorphe non côté substrat RA_{O} est plus grand que le rapport de concentration RAs de liant amorphe côté substrat (52).

4. Convertisseur de longueur d'onde (1) selon l'une quelconque des revendications 1 à 3, dans lequel le coefficient d'expansion thermique du liant amorphe (52) est plus petite que le coefficient d'expansion thermique des particules de liant (51).

5. Convertisseur de longueur d'onde (1) selon l'une quelconque des revendications 1 à 4, dans lequel les particules de liant (51) sont des particules creuses ou des particules mésoporeuses.

6. Convertisseur de longueur d'onde (1) selon l'une quelconque des revendications 1 à 5, dans lequel une matière des particules de liant (51) est un oxyde de métal ou un composé fluor.

7. Convertisseur de longueur d'onde (1) selon l'une quelconque des revendications 1 à 6, dans lequel la matière du liant amorphe (52) est du verre de silice utilisant au moins l'un ou l'autre du polysilazane et d'un dérivé de polysilazane en tant que précurseur.

8. Convertisseur de longueur d'onde (1) selon l'une quelconque des revendications 1 à 7, dans lequel le coefficient d'expansion thermique des particules de liant (51) est 1 x 10⁻⁶/K ou plus.

9. Convertisseur de longueur d'onde (1) selon l'une quelconque des revendications 1 à 7, dans lequel l'indice de réfraction des particules de liant (51) est 1,43 ou moins.

10. Convertisseur de longueur d'onde (1) selon l'une quelconque des revendications 1 à 9, dans lequel la partie formant substrat (10) est constituée de métal.
